(19)

**Europäisches Patentamt**
**European Patent Office**
**Office européen des brevets**

(11) **EP 4 632 822 A1**

(12) **EUROPEAN PATENT APPLICATION**
published in accordance with Art. 153(4) EPC

(43) Date of publication:
**15.10.2025 Bulletin 2025/42**

(21) Application number: 23900722.2

(22) Date of filing: 07.12.2023

(51) International Patent Classification (IPC):
*H01L 29/872* (2006.01)   *H01L 21/329* (2006.01)
*H01L 29/47* (2006.01)   *H01L 29/861* (2006.01)
*H01L 29/868* (2006.01)

(52) Cooperative Patent Classification (CPC):
**H10D 8/00; H10D 8/50; H10D 8/60; H10D 48/021; H10D 64/64**

(86) International application number:
**PCT/JP2023/043807**

(87) International publication number:
**WO 2024/122610 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.12.2022 JP 2022197276**

(71) Applicants:
- **Tamura Corporation**
  **Tokyo 178-8511 (JP)**
- **Novel Crystal Technology, Inc.**
  **Sayama-shi, Saitama 350-1328 (JP)**

(72) Inventor: **TAKATSUKA, Akio**
  **Sayama-Shi, Saitama 350-1328 (JP)**

(74) Representative: **Betten & Resch**
  **Patent- und Rechtsanwälte PartGmbB**
  **Maximiliansplatz 14**
  **80333 München (DE)**

(54) **JUNCTION BARRIER SCHOTTKY DIODE AND PRODUCTION METHOD THEREFOR**

(57)    Provided is a junction barrier Schottky diode 1 equipped with an n-type semiconductor layer 11 having a plurality of trenches 111, a plurality of p-type semiconductor parts 12 disposed so as to be in contact with the inner surfaces of the trenches 111, and an anode electrode 13 disposed so as to be in contact with mesa-shaped portions 112 of the n-type semiconductor layer 11, wherein the p-type semiconductor parts 12 each comprise a first portion 121, which covers the inner surface of the trench 111, and a second portion 122, which covers the brims of the trench 111 in the first surface 113 of the n-type semiconductor layer 11.

*FIG. 1*

## Description

Technical Field

The present invention relates to a junction barrier Schottky diode and a production method therefor.

Background Art

A trench junction barrier Schottky (JBS) diode is known which includes an n-type semiconductor layer formed on an n-type semiconductor substrate and having trenches opening on a surface opposite to the n-type semiconductor substrate, p-type semiconductor layers buried in the trenches of the n-type semiconductor layer, an anode electrode formed on the n-type semiconductor layer so as to be in contact with the p-type semiconductor layers, and a cathode electrode formed on a surface of the n-type semiconductor substrate opposite to the n-type semiconductor layer (see Patent Literature 1).

In the trench JBS diode described in Patent Literature 1, when reverse voltage is applied between the anode electrode and the cathode electrode, the current does not flow due to the Schottky barrier, and at this time, depletion layers spread from the p-type semiconductor layers and close channels between adjacent p-type semiconductor layers, hence, leakage current is effectively suppressed.

Citation List

Patent Literature

Patent Literature 1: JP 2019/36593A

Summary of Invention

Technical Problem

In the method for manufacturing a trench JBS diode described in Patent Literature 1, in order to bury the p-type semiconductor layers in the trenches of the n-type semiconductor layer, a p-type semiconductor film is deposited on the entire surface of the n-type semiconductor layer, and after that, a portion of the deposited p-type semiconductor film located outside the trenches is removed by a planarization process such as CMP (Chemical Mechanical Polishing).

However, the polishing rate of the planarization process such as CMP has a certain in-plane non-uniformity in principle, which may cause variations in the shape, etc. of the p-type semiconductor layers buried in the trenches, resulting in in-plane variation in the electrical characteristics of the trench JBS diode.

It is an object of the invention to provide a junction barrier Schottky diode in which variation in the shape of p-type semiconductor portions formed in trenches of an n-type semiconductor layer is suppressed, and a method for producing the same.

Solution to Problem

To achieve the above-mentioned object, an aspect of the present invention provides a junction barrier Schottky diode and a method for producing a junction barrier Schottky diode defined below.

(1) A junction barrier Schottky diode, comprising:

an n-type semiconductor layer comprising an n-type semiconductor and having a plurality of trenches that open on a first surface;
a plurality of p-type semiconductor portions that comprise a p-type semiconductor and are provided in contact, respectively, with inner surfaces of the plurality of trenches;
an anode electrode that is provided on the first surface of the n-type semiconductor layer and on the plurality of p-type semiconductor portions so as to be in contact with a mesa-shaped portion between the plurality of trenches of the n-type semiconductor layer; and
a cathode electrode provided, directly or through another layer, on a second surface of the n-type semiconductor layer opposite to the first surface,
wherein electron affinity $\chi_p$ and work function $\varphi_p$ of the p-type semiconductor and electron affinity $\chi_n$ and work function $\varphi_n$ of the n-type semiconductor satisfy a condition represented by an expression: $\chi_n - \chi_p > \varphi_p - \varphi_n$, and
wherein each of the plurality of p-type semiconductor portions comprises a first portion covering the inner surface of the trench and a second portion covering an edge of an opening of the trench on the first surface of the n-type semiconductor layer.

(2) The junction barrier Schottky diode defined in (1), wherein the trenches are filled respectively with the first portions of the plurality of p-type semiconductor portions.

(3) The junction barrier Schottky diode defined in (1), wherein gaps above the p-type semiconductor portions in the plurality of trenches are filled with a portion of the anode electrode.

(4) The junction barrier Schottky diode defined in (1), wherein the n-type semiconductor layer and the p-type semiconductor portions comprise different semiconductors.

(5) The junction barrier Schottky diode defined in (4), wherein the n-type semiconductor layer comprises a gallium oxide-based semiconductor.

(6) The junction barrier Schottky diode defined in (5), wherein the p-type semiconductor includes $Cu_2O$, $NiO$, $Ag_2O$, polycrystalline Si, single crystal Si, amor-

phous Si, SnO, $Rh_2O_3$, $Ir_2O_3$, or CuO.

(7) A method for producing a junction barrier Schottky diode, comprising:

forming a plurality of trenches on a first surface of an n-type semiconductor layer that comprises an n-type semiconductor;
forming a plurality of p-type semiconductor portions in contact, respectively, with inner surfaces of the plurality of trenches by depositing a p-type semiconductor on the entire surface of the n-type semiconductor layer on the first surface side and patterning the p-type semiconductor;
forming an anode electrode on the first surface of the n-type semiconductor layer and on the plurality of p-type semiconductor portions so as to be in contact with a mesa-shaped portion between the plurality of trenches of the n-type semiconductor layer; and
forming a cathode electrode, directly or through another layer, on a second surface of the n-type semiconductor layer opposite to the first surface,
wherein electron affinity $\chi_p$ and work function $\varphi_p$ of the p-type semiconductor and electron affinity $\chi_n$ and work function $\varphi_n$ of the n-type semiconductor satisfy a condition represented by an expression: $\chi_n - \chi_p > \varphi_p - \varphi_n$, and
wherein each of the plurality of p-type semiconductor portions comprises a first portion covering the inner surface of the trench and a second portion covering an edge of an opening of the trench on the first surface of the n-type semiconductor layer.

(8) The method for producing a junction barrier Schottky diode defined in (7), wherein in the forming the plurality of p-type semiconductor portions, the plurality of p-type semiconductor portions are formed by patterning a single p-type semiconductor film using lithography.

(9) The method for producing a junction barrier Schottky diode defined in (7), wherein in the forming the plurality of p-type semiconductor portions, the plurality of p-type semiconductor portions are formed by patterning using lift-off.

Advantageous Effects of Invention

According to the invention, it is possible to provide a junction barrier Schottky diode in which variation in the shape of p-type semiconductor portions formed in trenches of an n-type semiconductor layer is suppressed, and a method for producing the same.

Brief Description of Drawings

(FIG. 1) FIG. 1 is a vertical cross-sectional view showing a junction barrier Schottky (JBS) diode in an embodiment of the present invention.
(FIG. 2A) FIG. 2A is a vertical cross-sectional view showing an example process of producing the JBS diode in the embodiment of the invention.
(FIG. 2B) FIG. 2B is a vertical cross-sectional view showing the example process of producing the JBS diode in the embodiment of the invention.
(FIG. 2C) FIG. 2C is a vertical cross-sectional view showing the example process of producing the JBS diode in the embodiment of the invention.
(FIG. 3A) FIG. 3A is a vertical cross-sectional view showing the example process of producing the JBS diode in the embodiment of the invention.
(FIG. 3B) FIG. 3B is a vertical cross-sectional view showing the example process of producing the JBS diode in the embodiment of the invention.
(FIG. 3C) FIG. 3C is a vertical cross-sectional view showing the example process of producing the JBS diode in the embodiment of the invention.
(FIG. 4A) FIG. 4A is a vertical cross-sectional view showing another example process of producing the JBS diode in the embodiment of the invention.
(FIG. 4B) FIG. 4B is a vertical cross-sectional view showing the other example process of producing the JBS diode in the embodiment of the invention.
(FIG. 4C) FIG. 4C is a vertical cross-sectional view showing the other example process of producing the JBS diode in the embodiment of the invention.
(FIG. 5) FIG. 5 is a vertical cross-sectional view showing a modification of the JBS diode in the embodiment of the invention.
(FIG. 6A) FIG. 6A is a vertical cross-sectional view showing an example process of producing the JBS diode as a comparative example in which p-type semiconductor portions are formed using a planarization process.
(FIG. 6B) FIG. 6B is a vertical cross-sectional view showing the example process of producing the JBS diode as the comparative example in which p-type semiconductor portions are formed using a planarization process.
(FIG. 6C) FIG. 6C is a vertical cross-sectional view showing the example process of producing the JBS diode as the comparative example in which p-type semiconductor portions are formed using a planarization process.
(FIG. 7A) FIG. 7A is a vertical cross-sectional view showing an example process of producing the JBS diode as another comparative example in which p-type semiconductor portions are formed using a resist mask applied to fill trenches.
(FIG. 7B) FIG. 7B is a vertical cross-sectional view showing the example process of producing the JBS diode as the other comparative example in which p-type semiconductor portions are formed using a resist mask applied to fill trenches.

(FIG. 7C) FIG. 7C is a vertical cross-sectional view showing the example process of producing the JBS diode as the other comparative example in which p-type semiconductor portions are formed using a resist mask applied to fill trenches.

(FIG. 8A) FIG. 8A is a vertical cross-sectional view showing the example process of producing the JBS diode as the other comparative example in which p-type semiconductor portions are formed using a resist mask applied to fill trenches.

(FIG. 8B) FIG. 8B is a vertical cross-sectional view showing the example process of producing the JBS diode as the other comparative example in which p-type semiconductor portions are formed using a resist mask applied to fill trenches.

(FIG. 8C) FIG. 8C is a vertical cross-sectional view showing the example process of producing the JBS diode as the other comparative example in which p-type semiconductor portions are formed using a resist mask applied to fill trenches.

Description of Embodiments

(Embodiment)

(Configuration of a JBS diode)

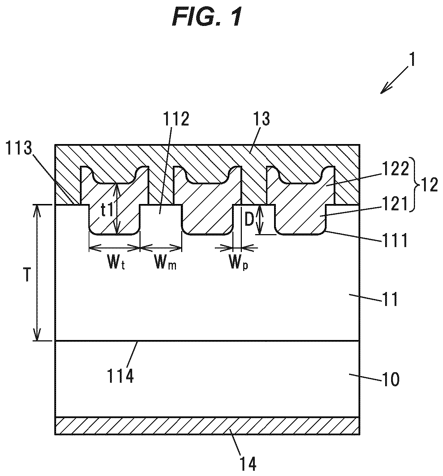

FIG. 1 is a vertical cross-sectional view showing a junction barrier Schottky (JBS) diode 1 in an embodiment of the invention. The JBS diode 1 is a vertical JBS diode that has a trench structure.

The JBS diode 1 includes an n-type semiconductor layer 11 that is formed of an n-type semiconductor and has plural trenches 111 which open on a first surface 113, plural p-type semiconductor portions 12 that are formed of a p-type semiconductor and are provided in contact, respectively, with inner surfaces of the plural trenches 111, an anode electrode 13 that is provided on the first surface 113 of the n-type semiconductor layer 11 and on the plural p-type semiconductor portions 12 so as to be in contact with mesa-shaped portions 112 between the plural trenches 111 of the n-type semiconductor layer 11, and a cathode electrode 14 provided, directly or through another layer, on a second surface 114 of the n-type semiconductor layer 11 opposite to the first surface 113.

Each of the plural p-type semiconductor portions 12 has a first portion 121 covering the inner surface of the trench 111 and a second portion 122 covering an edge of an opening of the trench 111 on the first surface 113 of the n-type semiconductor layer 11.

Typically, the JBS diode 1 includes an n-type semiconductor substrate 10 as a base for epitaxial growth of the n-type semiconductor layer 11, and the second surface 114 of the n-type semiconductor layer 11 is in contact with the n-type semiconductor substrate 10, as shown in FIG. 1. In this case, the cathode electrode 14 is provided on a surface of the n-type semiconductor substrate 10 opposite to the n-type semiconductor layer 11. In other words, the cathode electrode 14 is provided on the second surface 114 of the n-type semiconductor layer 11 through the n-type semiconductor substrate 10.

The n-type semiconductor layer 11 and the anode electrode 13 form a Schottky junction, and the JBS diode 1 uses the rectifying properties of this Schottky junction. In the JBS diode 1, a potential barrier at an interface between the anode electrode 13 and the n-type semiconductor layer 11 as viewed from the n-type semiconductor layer 11 is lowered by applying forward voltage between the anode electrode 13 and the cathode electrode 14 (positive potential on the anode electrode 13 side), allowing a current to flow from the anode electrode 13 to the cathode electrode 14.

On the other hand, when reverse voltage is applied between the anode electrode 13 and the cathode electrode 14 (negative potential on the anode electrode 13 side), the current does not flow due to the Schottky barrier. At this time, since depletion layers spread from the p-type semiconductor portions 12 inside the trenches 111 and close channels in the mesa-shaped portions 112 between adjacent trenches 111, leakage current is effectively suppressed.

The JBS diode 1 in the present embodiment has a trench JBS structure and thus can have a high withstand voltage without an increase in resistance of the n-type semiconductor layer 11. In other words, the JBS diode 1 is a Schottky barrier diode having a high withstand voltage and low loss.

The n-type semiconductor substrate 10 is formed of a single crystal of an n-type gallium oxide-based semiconductor containing a group IV element such as Si or Sn as a donor. A donor concentration in the n-type semiconductor substrate 10 is, e.g., not less than $1.0 \times 10^{16}$ cm$^{-3}$ and not more than $1.0 \times 10^{22}$ cm$^{-3}$, preferably not less than $1.0 \times 10^{18}$ cm$^{-3}$ and not more than $1.0 \times 10^{22}$ cm$^{-3}$. A thickness of the n-type semiconductor substrate 10 is, e.g., not less than 5 $\mu$m and not more than 650 $\mu$m.

The gallium oxide-based semiconductor here is $Ga_2O_3$ or is $Ga_2O_3$ doped with one or both of Al and In, and has a composition represented by $(Ga_xAl_yIn_{(1-x-y)})_2O_3$ ($0 < x \leq 1$, $0 \leq y < 1$, $0 < x+y \leq 1$). $Ga_2O_3$ has a wider band gap when doped with Al and a narrower band gap when doped with In. The single crystal of the gallium oxide-based semiconductor mentioned above typically has a $\beta$-crystal structure. For example, $Ga_2O_3$, which is a typical example of gallium oxide-based semiconductor, has a band gap energy of 4.5 to 4.9 eV and a breakdown field strength of about 8.0 MV/cm.

The n-type semiconductor layer 11 is formed of a single crystal of an n-type gallium oxide-based semiconductor containing a group IV element such as Si or Sn as a donor. A donor concentration in the n-type semiconductor layer 11 is lower than the donor concentration in the n-type semiconductor substrate 10. The n-type semiconductor layer 11 is, e.g., an epitaxial film epitaxially grown on the n-type semiconductor substrate 10.

A high-donor-concentration layer containing a high concentration of donor may be formed between the n-type semiconductor substrate 10 and the n-type semiconductor layer 11. The high-donor-concentration layer is used in case where, e.g., the n-type semiconductor layer 11 is epitaxially grown on the n-type semiconductor substrate 10. At the early growth stage of the n-type semiconductor layer 11, the amount of dopant incorporated thereinto is unstable and an acceptor impurity is diffused from the n-type semiconductor substrate 10. Thus, resistance may increase in a region of the n-type semiconductor layer 11 close to the interface with the n-type semiconductor substrate 10 when the n-type semiconductor layer 11 is grown directly on the n-type semiconductor substrate 10. The high-donor-concentration layer is used to avoid such problems. A donor concentration in the high-donor-concentration layer is set to, e.g., higher than the donor concentration in the n-type semiconductor layer 11, and is more preferably set to not less than 10 times higher than the donor concentration in the n-type semiconductor layer 11.

As the donor concentration in the n-type semiconductor layer 11 increases, electrical field strength in each part of the JBS diode 1 increases. The donor concentration in the n-type semiconductor layer 11 is, e.g., not less than $2\times10^{14}$ cm$^{-3}$ and not more than $4\times10^{17}$ cm$^{-3}$. In order for the JBS diode 1 to have a withstand voltage of not less than 400V, the donor concentration in the n-type semiconductor layer 11 is preferably not more than $4\times10^{17}$ cm$^{-3}$, and more preferably, not less than $8\times10^{15}$ cm$^{-3}$ and not more than $4\times10^{17}$ cm$^{-3}$.

Then, in order for the JBS diode 1 to have a withstand voltage of not less than 600V, the donor concentration in the n-type semiconductor layer 11 is preferably not more than $2\times10^{17}$ cm$^{-3}$, and more preferably, not less than $4\times10^{15}$ cm$^{-3}$ and not more than $2\times10^{17}$ cm$^{-3}$. In order for the JBS diode 1 to have a withstand voltage of not less than 1200V, the donor concentration in the n-type semiconductor layer 11 is preferably not more than $1\times10^{17}$ cm$^{-3}$, and more preferably, not less than $2\times10^{15}$ cm$^{-3}$ and not more than $1\times10^{17}$ cm$^{-3}$.

In order for the JBS diode 1 to have a withstand voltage of not less than 2200V, the donor concentration in the n-type semiconductor layer 11 is preferably not more than $8\times10^{16}$ cm$^{-3}$, and more preferably, not less than $1.6\times10^{15}$ cm$^{-3}$ and not more than $8\times10^{16}$ cm$^{-3}$. In order for the JBS diode 1 to have a withstand voltage of not less than 3300V, the donor concentration in the n-type semiconductor layer 11 is preferably not more than $5\times10^{16}$ cm$^{-3}$, and more preferably, not less than $1\times10^{15}$ cm$^{-3}$ and not more than $5\times10^{16}$ cm$^{-3}$.

In order for the JBS diode 1 to have a withstand voltage of not less than 5000V, the donor concentration in the n-type semiconductor layer 11 is preferably not more than $3\times10^{16}$ cm$^{-3}$, and more preferably, not less than $6\times10^{14}$ cm$^{-3}$ and not more than $3\times10^{16}$ cm$^{-3}$. In order for the JBS diode 1 to have a withstand voltage of not less than 10000V, the donor concentration in the n-type semiconductor layer 11 is preferably not more than $1\times10^{16}$ cm$^{-3}$, and more preferably, not less than $2\times10^{14}$ cm$^{-3}$ and not more than $1\times10^{16}$ cm$^{-3}$.

When a thickness T of the n-type semiconductor layer 11 is designed so that an electric field generated in each part when applying a reverse voltage equal to the design withstand voltage to the JBS diode 1 is smaller than the breakdown field, the larger the depth D of the trench 111, the lower the electric field at the Schottky interface between the anode electrode 13 and the first surface 113 when reverse voltage is applied. On the other hand, if the depth D of the trench 111 is too large, electrical resistance between the anode electrode 13 and the cathode electrode 14 of the JBS diode 1 increases. Thus, the depth D of the trench 111 is preferably not less than 0.5 $\mu$m and not more than 5 $\mu$m.

The thickness T of the n-type semiconductor layer 11 has, e.g., a value obtained by adding 0.5 to 110 $\mu$m to the depth D of the trench 111 measured from the first surface 113. And in order for the JBS diode 1 to have a withstand voltage of not less than 400V, the thickness T of the n-type semiconductor layer 11 preferably has a value obtained by adding 0.6 to 9 $\mu$m to the depth D of the trench 111, more preferably has a value obtained by adding 0.6 to 6 $\mu$m.

Furthermore, in order for the JBS diode 1 to have a withstand voltage of not less than 600V, the thickness T of the n-type semiconductor layer 11 preferably has a value obtained by adding 0.8 to 11 $\mu$m to the depth D of the trench 111, more preferably has a value obtained by adding 0.8 to 7 $\mu$m. In order for the JBS diode 1 to have a withstand voltage of not less than 1200V, the thickness T of the n-type semiconductor layer 11 preferably has a value obtained by adding 1.5 to 20 $\mu$m to the depth D of the trench 111, more preferably has a value obtained by adding 1.5 to 12 $\mu$m.

In order for the JBS diode 1 to have a withstand voltage of not less than 2200V, the thickness T of the n-type semiconductor layer 11 preferably has a value obtained by adding 4 to 40 $\mu$m to the depth D of the trench 111, more preferably has a value obtained by adding 4 to 25 $\mu$m. In order for the JBS diode 1 to have a withstand voltage of not less than 3300V, the thickness T of the n-type semiconductor layer 11 preferably has a value obtained by adding 5 to 50 $\mu$m to the depth D of the trench 111, more preferably has a value obtained by adding 5 to 30 $\mu$m.

In order for the JBS diode 1 to have a withstand voltage of not less than 5000V, the thickness T of the n-type semiconductor layer 11 preferably has a value obtained by adding 7 to 90 $\mu$m to the depth D of the trench 111, more preferably has a value obtained by adding 7 to 55 $\mu$m. In order for the JBS diode 1 to have a withstand voltage of not less than 10000V, the thickness T of the n-type semiconductor layer 11 preferably has a value obtained by adding 12 to 180 $\mu$m to the depth D of the trench 111, more preferably has a value obtained by adding 12 to

110 $\mu$m.

When a width $W_t$ of the trench 111 is narrower, the conduction loss can be more reduced but it is more difficult to manufacture, causing a decrease in production yield. Therefore, not less than 0.3 $\mu$m and not more than 5 $\mu$m is preferable.

As a width $W_m$ of the mesa-shaped portion 112 between adjacent trenches 111 of the n-type semiconductor layer 11 decreases, the electric field strength directly below the anode electrode 13 in the mesa-shaped portion 112 and the electric field strength at the junction between the n-type semiconductor layer 11 and the p-type semiconductor film 12 decrease. To effectively reduce these electric field strengths, the width $W_m$ of the mesa-shaped section 112 is preferably not more than 5 $\mu$m. On the other hand, the smaller the width $W_m$ of the mesa-shaped portion 112, the more difficult it is to manufacture the trench 111, hence, the width $W_m$ of the mesa-shaped portion 112 is preferably not less than 0.25 $\mu$m.

The anode electrode 13 is configured such that a portion in contact with the n-type semiconductor layer 11 is formed of a material that forms a Schottky junction with the n-type semiconductor layer 11. That is, the anode electrode 13 when having a single layer structure is entirely formed of a material that forms a Schottky junction with the n-type semiconductor layer 11, and the anode electrode 13 when having a multilayer structure is configured such that at least a layer in contact with the n-type semiconductor layer 11 is formed of a material that forms a Schottky junction with the n-type semiconductor layer 11.

As the material of the portion of the anode electrode 13 that is in contact with the n-type semiconductor layer 11, it is possible to use, e.g., Pt, Ni, Au, Cu, Mo, W, Fe, Pd, or Cr, which forms a Schottky junction with the n-type semiconductor layer 11 formed of a gallium oxide-based semiconductor.

In case that, e.g., the n-type semiconductor layer 11 is formed of $Ga_2O_3$, the turn-on voltage of the JBS diode 1 is not less than 0.7 and not more than 1.2V when using Pt or Ni as the material of the anode electrode 13, and the turn-on voltage of the JBS diode 1 is not less than 0.3 and not more than 0.8V when using Mo as the material of anode electrode 13.

In the JBS diode 1, a potential barrier is formed in the mesa-shaped portion 112. Therefore, the turn-on voltage depends on the width $W_m$ of the mesa-shaped portion 112 and increases as the width $W_m$ decreases.

The field strength in the JBS diode 1 is affected by the width $W_m$ of the mesa portion 112 between two adjacent trenches 111 and the depth D of the trench 111, etc., as described above but is hardly affected by the planar pattern of the trenches 111. Thus, the planar pattern of the trenches 111 on the n-type semiconductor layer 11 is not specifically limited. The plural trenches 111 may be included in one continuous trench as long as the planar pattern of the trenches 111 is a planar pattern that forms the mesa-shaped portions 112 (e.g., a mesh pattern).

When the JBS diode 1 includes the n-type semiconductor substrate 10, the cathode electrode 14 is in ohmic contact with the n-type semiconductor substrate 10. The cathode electrode 14 is formed of a metal such as Ti. The cathode electrode 14 may have a multilayer structure formed by stacking different metal films, e.g., Ti/Au, Ti/Al, Ti/Ni/Au, or Ti/Al/Ni/Au. For reliable ohmic contact between the cathode electrode 14 and the n-type semiconductor substrate 10, the cathode electrode 14 is preferably configured such that a layer in contact with the n-type semiconductor substrate 10 is formed of Ti. When the JBS diode 1 does not include the n-type semiconductor substrate 10 and the cathode electrode 14 is directly connected to the n-type semiconductor layer 11, the cathode electrode 14 is in ohmic contact with the n-type semiconductor layer 11.

The p-type semiconductor portions 12 are used to improve the surge resistance of the JBS diode 1. The p-type semiconductor portions 12 are formed by deposition using a sputtering method or a CVD method, etc., and is not a region which is formed as part of the n-type semiconductor layer 11 by implanting an impurity into the inner surfaces of the trenches 111 using an ion implantation method.

Normally, pn diodes have a higher on-voltage (forward turn-on voltage) than Schottky diodes. Therefore, it is possible to design so that a pn diode portion (a pn junction portion between the p-type semiconductor portion 12 and the n-type semiconductor layer 11) does not turn on at the voltage at which the JBS diode 1 turns on. It is possible to design such that, e.g., the on-voltage of the JBS diode 1 is about 1V and the on-voltage of the pn diode portion is about 2V.

This allows for high-speed operation inherent to Schottky diode since the pn diode portion does not turn on during normal operation of the JBS diode 1. On the other hand, when an inrush current occurs, the voltage of the JBS diode 1 rises and reaches the voltage at which the pn diode portion turns on, and current is injected from the p-type semiconductor portions 12 to the n-type semiconductor layer 11.

At that time, resistance of the JBS diode 1 decreases and a large current called inrush current flows through JBS diode 1 but the voltage rise is suppressed, hence, temperature rise is suppressed and damage to the JBS diode 1 due to inrush current can be prevented.

The p-type semiconductor portions 12 are formed of a material that satisfies the condition represented by Expression 1 below so that a potential barrier is formed between itself and the n-type semiconductor layer 11. In Expression 1, $\chi_p$ and $\varphi_p$ are respectively electron affinity and work function of the p-type semiconductor which is the material of the p-type semiconductor portions 12, and $\chi_n$ and $\varphi_n$ are respectively electron affinity and work function of the n-type semiconductor which is the material of the n-type semiconductor layer 11. The work function mentioned above is the energy of the Fermi level as seen from the vacuum level. For example, $\chi_n$ of $Ga_2O_3$, which is a typical material of the n-type semiconductor layer 11, is about 4.0 eV, and $\varphi_n$ varies depending on a carrier concentration in the n-type semiconductor layer 11 but is about 4.3 to 4.0 eV in the carrier concentration range of $1 \times 10^{14}$ cm$^{-3}$ to $1 \times 10^{19}$ cm$^{-3}$.

$$\chi_n - \chi_p > \varphi_p - \varphi_n \quad \text{... (Expression 1)}$$

Materials which can be used as the material of the p-type semiconductor portions 12 and can satisfy the condition represented by Expression 1 above are, e.g., p-type semiconductors such as $Cu_2O$, $NiO$, $Ag_2O$, polycrystalline Si, single crystal Si, amorphous Si, SnO, $Rh_2O_3$, $Ir_2O_3$, and CuO. Mixtures containing a p-type semiconductor such as $Cu_2O$, $NiO$, $Ag_2O$, polycrystalline Si, single crystal Si, amorphous Si, SnO, $Rh_2O_3$, $Ir_2O_3$, or CuO at a concentration sufficient to cause the p-type semiconductor portions 12 to be p-type can also be used as the material of the p-type semiconductor portions 12.

That is, the p-type semiconductor as the material of the p-type semiconductor portions 12 includes, e.g., $Cu_2O$, $NiO$, $Ag_2O$, polycrystalline Si, single crystal Si, amorphous Si, SnO, $Rh_2O_3$, $Ir_2O_3$, or CuO. $Cu_2O$, $NiO$ and SnO exhibit p-type conductivity without adding a dopant but may contain an acceptor impurity such as Li or nitrogen (N). Polycrystalline Si, single crystal Si, and amorphous Si preferably contain an acceptor impurity such as B or Al.

A carrier concentration in the p-type semiconductor portions 12 is preferably higher than the carrier concentration in the n-type semiconductor layer 11 so that the depletion layers generated in the p-type semiconductor portions 12 from the interface with the n-type semiconductor layer 11 do not increase in thickness and reach the anode electrode 13 when reverse voltage is applied to the JBS diode 1.

As described above, the p-type semiconductor portion 12 has the second portion 122 covering an edge of an opening of the trench 111 on the first surface 113 of the n-type semiconductor layer 11, in addition to the first portion 121 covering the inner surface of the trench 111. The second portion 122 is provided as a result of a process of suppressing reach of etching to the first portion 121 due to misalignment of etching mask or lift-off resist at the time of forming the p-type semiconductor portions 12 by patterning in the process of producing the JBS diode 1 described below. The first portion 121 fills the trench 111.

A thickness t1 of the p-type semiconductor portion 12 preferably satisfies the condition represented by Expression 2 below to obtain the desired withstand voltage of the JBS diode 1. In Expression 2, $V_{BR}$ is the desired withstand voltage (design withstand voltage), $N_D$ is the carrier concentration in the n-type semiconductor layer 11, $N_A$ is the carrier concentration in the p-type

semiconductor portions 12, $\varepsilon_n$ is the electric permittivity of the n-type semiconductor layer 11, and q is the elementary charge.

$$t1 \geq \sqrt{\frac{2\varepsilon_n N_D V_{BR}}{q N_A^2}} \quad \text{... (Expression 2)}$$

In the JBS diode 1, the electric field generated at the interface between the n-type semiconductor layer 11 and the p-type semiconductor portions 12 under application of reverse voltage can be reduced by reducing the carrier concentration $N_A$ in the p-type semiconductor portions 12, but it is necessary to increase the thickness t1 of the p-type semiconductor portions 12 accordingly as shown in Expression 2. In the JBS diode 1, the p-type semiconductor portions 12 fill the trenches 111, which allows the p-type semiconductor portions 12 to have the thickness t1 of not less than the trench depth D. As a result, it is possible to further reduce the carrier concentration $N_A$, thereby further reducing the electric field generated at the interface between the n-type semiconductor layer 11 and the p-type semiconductor portions 12 under application of reverse voltage

(Method for producing the JBS diode)

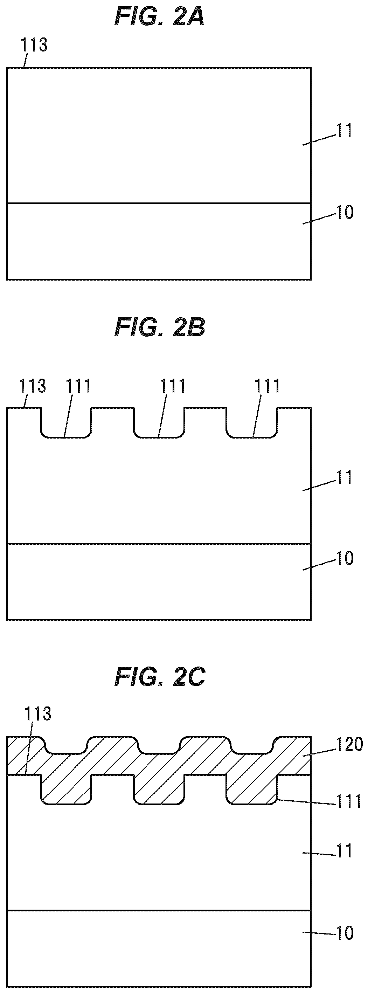

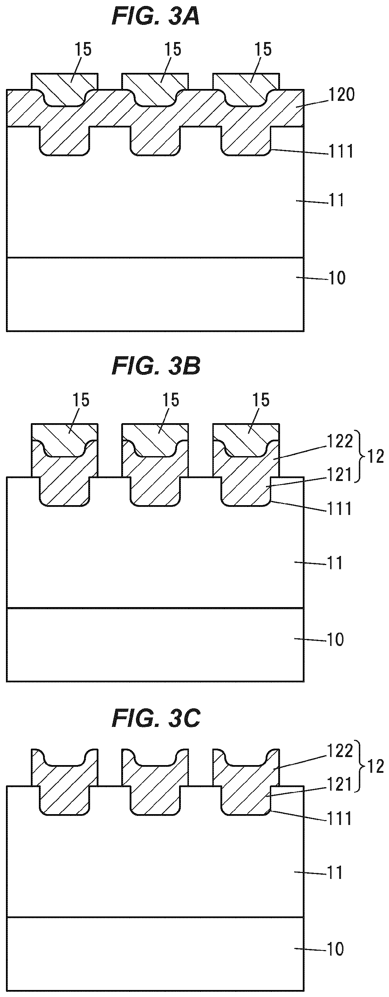

FIGS. 2A to 2C and 3A to 3C are explanatory vertical cross-sectional views showing an example process of producing the JBS diode 1 in the embodiment of the invention. In this method, the plural p-type semiconductor portions 12 are formed by patterning a single film-shaped p-type semiconductor 120 using lithography.

First, as shown in FIG. 2A, a single crystal of a gallium oxide-based semiconductor with a controlled donor concentration is epitaxially grown on the n-type semiconductor substrate 10 by a HVPE method, a CVD method, or an MBE method, etc., thereby forming the n-type semiconductor layer 11.

Next, as shown in FIG. 2B, plural trenches 111 are formed on the first surface 113 of the n-type semiconductor layer 11 by photolithography and dry etching, etc. The preferable conditions of the dry etching used to form the trenches 111 are, e.g., use of $BCl_3$ (30 sccm) as an etching gas, pressure of 1.0 Pa, antenna power of 160W, bias power of 17W, and duration of 90 minutes.

Next, as shown in FIG. 2C, the p-type semiconductor 120 is deposited on the entire surface of the n-type semiconductor layer 11 on the first surface 113 side by the sputtering method or the CVD method, etc., thereby forming the single film-shaped p-type semiconductor 120. The p-type semiconductor 120 covers the inner surfaces of the trenches 111 and the first surface 113 outside the trenches 111.

When using, e.g., $Cu_2O$ as the material of the p-type semiconductor 120, it is possible to use the method described in Non-Patent Literature "Appl. Phys. Lett. 111, 093501 (2017), Fabrication and characterization of sputtered Fabrication and characterization of sputtered Cu$_2$O:N/c-Si heterojunction diode". When using NiO as the material of the p-type semiconductor 120, it is possible to use the method described in Non-Patent Literature "Appl. Phys. Lett. 117, 022104 (2020), A 1.86-kV double-layered NiO/β-Ga$_2$O$_3$-vertical pn heterojunction diode". Furthermore, when using polycrystalline Si, amorphous Si, or single crystal Si as the material of the p-type semiconductor 120, it is possible to respectively use known deposition methods.

Next, as shown in FIG. 3A, photoresists 15 are formed on the p-type semiconductor 120 by photolithography. The photoresists 15 are formed above the trenches 111 so as to have a larger width than that of the trenches 111.

Next, as shown in FIG. 3B, the p-type semiconductor 120 is etched using the photoresists 15 as masks to transfer the pattern of the photoresists 15 to the p-type semiconductor 120, thereby forming the p-type semiconductor portions 12. When, e.g., the p-type semiconductor 120 is formed of Cu$_2$O, a wet etching using an acidic solution such as a buffered hydrofluoric acid solution, dilute hydrofluoric acid, diluted aqua regia, or dilute sulfuric acid, or a dry etching is used to etch the p-type semiconductor 120.

At this time, since the width of the photoresists 15 is larger than the width of the trenches 111, the etching does not reach the p-type semiconductor 120 in the trenches 111 even when production process errors occur at the positions where the photoresists 15 are formed, and variation in the shape of the first portions 121 of the p-type semiconductor portions 12 formed in the trenches 111 is suppressed. Then, since the width of the photoresists 15 is larger than the width of the trenches 111, a portion of the p-type semiconductor 120 near the edges of the openings of the trenches 111 are left as the second portions 122 of the p-type semiconductor portions 12.

Taking into account processing variation in the photoresists 15 resulting from the alignment accuracy of an alignment exposure device for forming the photoresists 15 and dimensional change or dimensional variation due to patterning process on the p-type semiconductor 120, a design value of a width $W_p$ of the second portions 122 located on the first surface 113 (a length from the edge of the trench 111 in the lateral direction) is set so that the second portions 122 are always formed on the first surface 113 of the n-type semiconductor layer 11. On the other hand, the width $W_p$ of the actually formed second portions 122 is preferably as small as possible. As a result, the width $W_p$ of the actually formed second portions 122 is, e.g., about 0.01 to 0.3 μm.

Next, as shown in FIG. 3C, the photoresists 15 on the p-type semiconductor portions 12 are removed. For example, an organic chemical agent such as NMP or acetone is used to remove the photoresists 15. After that, the anode electrode 13 and the cathode electrode 14 are formed, thereby obtaining the JBS diode 1. For example, an electron beam evaporation method is used to form the anode electrode 13 and the cathode electrode 14.

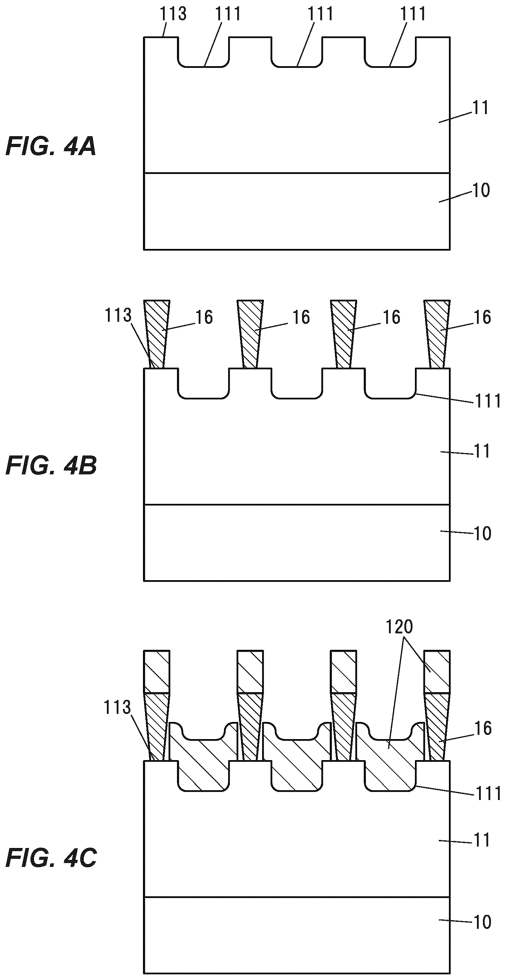

FIGS. 4A to 4C are vertical cross-sectional views showing another example process of producing the JBS diode 1 in the embodiment of the invention. In this method, the plural p-type semiconductor portions 12 are formed by patterning using lift-off. First, as shown in FIG. 4A, the steps up to the step of forming the trenches 111 shown in FIG. 2B are performed in the same manner as in the method described above.

Next, as shown in FIG. 4B, photoresists 16 for lift-off are formed on the first surface 113, such as upper surfaces of the mesa-shaped portions 112 of the n-type semiconductor layer 11, by photolithograph, etc. The photoresists 16 are formed so as not to be in contact with the edges of the trenches 111. Therefore, the width of the photoresists 16 formed on, e.g., the mesa-shape portions 112 is smaller than the width of the mesa-shape portions 112.

The photoresists 16 may be of a vertical type. However, by forming the photoresists 16 having an inverted tapered shape with an inclined sidewall as shown in FIG. 4B, it is possible to effectively suppress adhesion to the sidewall of the p-type semiconductor 120 deposited by the sputtering method, etc. in a later process. This facilitates removal of unnecessary portions of the p-type semiconductor 120 on the photoresists 16 in the lift-off process performed later, and also improves processing accuracy of the p-type semiconductor portions 12.

Since the photoresists 16 are formed so as not to be in contact with the edges of the trenches 111, any portion of the photoresists 16 does not enter the trenches 111 even when production process errors occur at the positions where the photoresists 16 are formed.

Next, as shown in FIG. 4C, the p-type semiconductor 120 is deposited on the entire surface of the n-type semiconductor layer 11 on the first surface 113 side by the sputtering method or the CVD method, etc. The p-type semiconductor 120 is deposited in the trenches 111, on the photoresists 16, and on a region of the first surface 113 outside the trenches 111 and not covered with the photoresists 16.

At this time, since the photoresists 16 are formed so as not to be in contact with the edges of the trenches 111, deposition of the p-type semiconductor 120 in the trenches 111 is not hindered by the photoresists 16, and variation in the shape of the first portions 121 of the p-type semiconductor portions 12 formed in the trenches 111 is suppressed.

Next, the photoresists 16, together with the p-type semiconductor 120 thereon, are removed, resulting in the state shown in FIG. 3C, thereby obtaining the p-type semiconductor portions 12. For example, an organic chemical agent such as NMP or acetone is used to remove the photoresists 16.

At this time, since the photoresists 16 are formed so as not to be in contact with the edges of the trenches 111, a portion of the p-type semiconductor 120 near the edges of the openings of the trenches 111 are left as the second portions 122 of the p-type semiconductor portions 12. After that, the anode electrode 13 and the cathode electrode 14 are formed, thereby obtaining the JBS diode 1.

Taking into account processing variation in the photoresists 16 resulting from the alignment accuracy of an alignment exposure device for forming the photoresists 16 and dimensional change or dimensional variation due to patterning process on the p-type semiconductor 120 using the lift-off process, a design value of the width $W_p$ of the second portions 122 located on the first surface 113 is set so that the second portions 122 are always formed on the first surface 113 of the n-type semiconductor layer 11. On the other hand, the width $W_p$ of the actually formed second portions 122 is preferably as small as possible. As a result, the width $W_p$ of the actually formed second portions 122 is, e.g., about 0.01 to 0.3 $\mu$m.

(Modification)

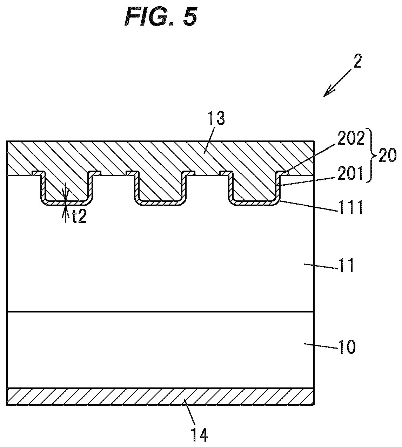

FIG. 5 is a vertical cross-sectional view showing a JBS diode 2 which is a modification of the JBS diode 1. The JBS diode 2 is different from the JBS diode 1 in that the trenches 111 are not filled with the first portions of the p-type semiconductor portions that cover the inner surfaces of trenches 111.

As shown in FIG. 5, first portions 201 of p-type semiconductor portions 20 of the JBS diode 2 do not fill the trenches 111. Therefore, gaps exist in the trenches 111 above the p-type semiconductor portions 20, and a portion of the anode electrode 13 fills the gaps. The p-type semiconductor portions 20 have a film shape and thus have lower electrical resistance than when arranged to fill the trenches 111. Thus, heat generation in the event of a surge current is small and damage to the connected portions therearound can be suppressed. In addition, since the electrical resistance of the p-type semiconductor portions 20 is small, it is possible to suppress energy loss during the switching operation of the JBS diode 2.

A thickness t2 of the film-shaped p-type semiconductor portions 20 preferably satisfies the condition represented by Expression 3 below to obtain the desired withstand voltage of the JBS diode 2. In Expression 3, $V_{BR}$ is the desired withstand voltage (design withstand voltage), $N_D$ is the carrier concentration in the n-type semiconductor layer 11, $N_A$ is the carrier concentration in the p-type semiconductor portions 12, $\varepsilon_n$ is the electric permittivity of the n-type semiconductor layer 11, and q is the elementary charge.

$$t2 \geq \sqrt{\frac{2\varepsilon_n N_D V_{BR}}{q N_A^2}} \ \ldots \text{(Expression 3)}$$

In case that, e.g., the carrier concentration in the n-type semiconductor layer 11 formed of a gallium oxide-based semiconductor is $1\times10^{16}$ cm$^{-3}$ and the carrier concentration in the p-type semiconductor portions 20

is $1\times10^{19}$ cm$^{-3}$, the withstand voltage of the JBS diode 2 can be not less than 1200V when the thickness of the p-type semiconductor portions 20 is not less than 200 nm.

The p-type semiconductor portions 20 of the JBS diode 2 can be formed by the same process as the p-type semiconductor portions 12 of the JBS diode 1. For example, the thickness of the p-type semiconductor 120 deposited in the step shown in FIG. 2C or FIG. 4C may be set to the extent that the p-type semiconductor 120 does not fill the trenches 111.

(Comparative examples)

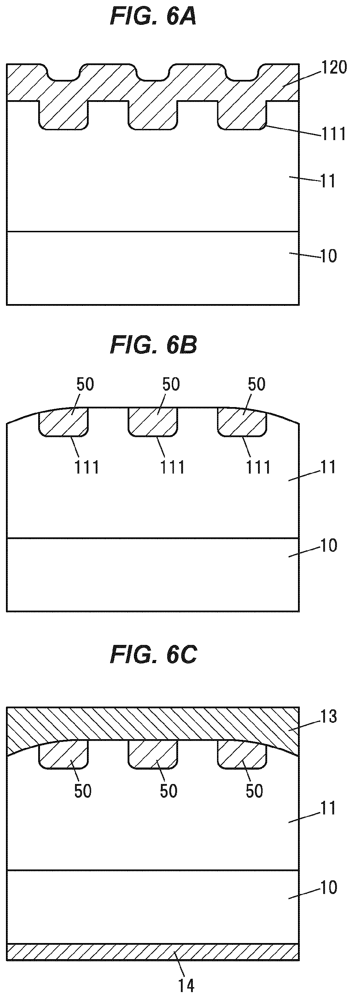

FIGS. 6A to 6C are vertical cross-sectional views showing an example process of producing the JBS diode as a comparative example in which the p-type semiconductor portions are formed using a planarization process. First, as shown in FIG. 6A, the steps up to the step of depositing the p-type semiconductor 120 shown in FIG. 2C are performed in the same manner as in the method described above.

Next, as shown in FIG. 6B, a portion of the p-type semiconductor 120 located outside the trenches 111 is removed by a planarization process such as CMP, thereby forming p-type semiconductor portions 50 buried in the trenches 111. At this time, variation occurs in the shape of the plural p-type semiconductor portions 50 since the polishing rate of the planarization process is nonuniform, and variation occurs also in the shape of the mesa-shaped portions between the trenches 111 since the first surface 113 of the n-type semiconductor layer 11 is unevenly removed.

The causes of non-uniformity in the polishing rate of the planarization process include, e.g., the fact that the polishing rate of the planarization process changes depending on the pattern density of the trenched 111, and that the polishing rate is higher at a portion near the edge when the JBS diode has a mesa shape as a whole.

Next, as shown in FIG. 6C, the anode electrode 13 and the cathode electrode 14 are formed. For example, an electron beam evaporation method is used to form the anode electrode 13 and the cathode electrode 14.

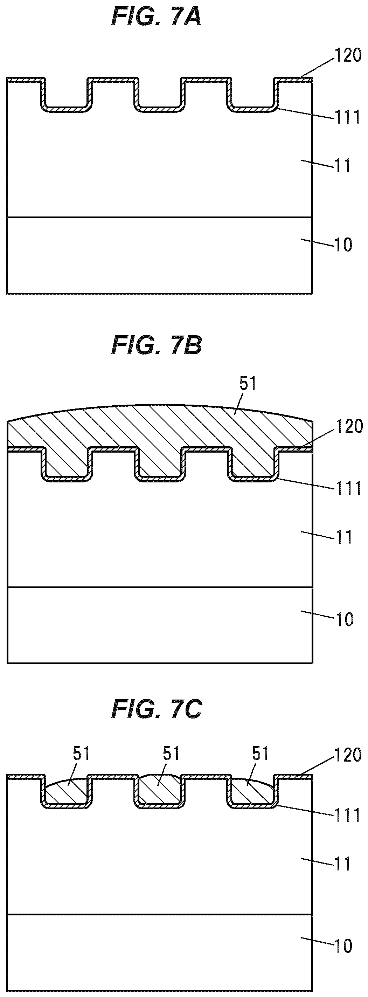

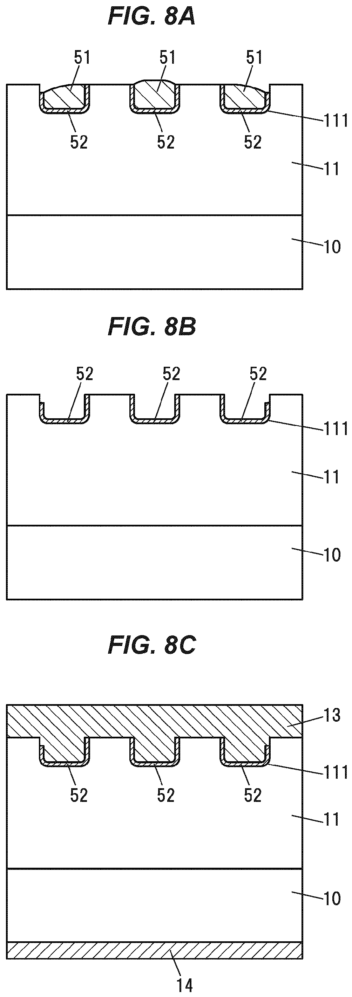

FIGS. 7A to 7C and 8A to 8C are vertical cross-sectional views showing an example process of producing the JBS diode as another comparative example in which the p-type semiconductor portions are formed using a resist mask applied to fill trenches 111.

First, as shown in FIG. 7A, plural trenches 111 are formed on the first surface 113 of the n-type semiconductor layer 11, and then a single film-shaped p-type semiconductor 120 is deposited on the entire surface of the n-type semiconductor layer 11 on the first surface 113 side by the sputtering method or the CVD method, etc. The p-type semiconductor 120 is formed to have a thickness to the extent of not filling the trenches 111, and covers the inner surfaces of the trenches 111 and the first surface 113 outside the trenches 111.

Next, as shown in FIG. 7B, a photoresist 51 is deposited on the p-type semiconductor 120 by a spin coating method, etc. so as to fill the gaps in the trenches 111. The thickness of the photoresist 51 to be deposited at this time depends on the surface profile of the n-type semiconductor layer 11 which varies depending on the pattern or depth of the trenches 111, and is thus different at each location on the n-type semiconductor layer 11 and has variation in the in-plane direction.

Next, as shown in FIG. 7C, the p-type semiconductor 120 on the first surface 113 is exposed by etching back the photoresist 51. For etching of the photoresist 51, e.g., a plasma asher device using oxygen plasma, etc., is used. At this time, variation occurs in the shape of the etch-backed photoresists 51 due to the variation in the thickness of the photoresist 51 before being etched back.

Next, as shown in FIG. 8A, the p-type semiconductor 120 is etched until the first surface 113 of the n-type semiconductor layer 11 is exposed, thereby forming p-type semiconductor portions 52 respectively in the trenches 111. At this time, variation occurs in the shape of the p-type semiconductor portions 52 formed in the trenches 111 due to the variation in the shape of the photoresists 51 serving as etching masks.

Next, as shown in FIG. 8B, the photoresists 51 are removed. For example, an organic chemical agent such as NMP or acetone is used to remove the photoresists 51.

Next, as shown in FIG. 8C, the anode electrode 13 and the cathode electrode 14 are formed. For example, an electron beam evaporation method is used to form the anode electrode 13 and the cathode electrode 14.

When using the methods in the two comparative examples described above, variations occur in the shapes of the p-type semiconductor portions 50 and 52 formed in the trenches 111 of the n-type semiconductor layer 11, which may result in in-plane variation in the electrical characteristics of the trench JBS diode.

(Effects of the embodiment)

In the embodiment of the invention described above, the in-plane variation in the electrical characteristics of the JBS diodes 1, 2 can be suppressed by suppressing the variation in the shapes of the first portions 121, 201 of the p-type semiconductor portions 12, 20 formed in the trenches 111.

Although the embodiment of the invention has been described, the invention is not intended to be limited to the embodiment, and the various kinds of modifications can be implemented without departing from the gist of the invention. For example, the n-type semiconductor layer 11 may be a layer formed of a material other than the gallium oxide-based semiconductor. Also in this case, the material of the p-type semiconductor portions 12 should be selected so that electron affinity $\chi_n$ and work function $\varphi_n$ of the material of the n-type semiconductor layer 11 and electron affinity $\chi_p$ and work function $\varphi_p$ of the material of the p-type semiconductor film 12 satisfy the condition represented by Expression 1 above.

As described above, the p-type semiconductor portions 12 are not formed as part of the n-type semiconductor layer 11 by ion implantation. Therefore, even when the n-type semiconductor layer 11 is formed of a material that is difficult to convert into p-type, such as a gallium oxide-based semiconductor, the p-type semiconductor portions 12 can be formed using a material different from the n-type semiconductor layer 11.

When the breakdown field strength of the n-type semiconductor layer 11 is large, it is possible to have a large withstand voltage while suppressing an increase in on-resistance. For this reason, the n-type semiconductor layer 11 is preferably formed of, e.g., a material with a breakdown field strength of not less than 1 MV/cm or a band gap energy of not less than 1.

In addition to the gallium oxide-based semiconductor, e.g., SiC with a breakdown field strength of 2.5 MV/cm and a band gap energy of 3.3 eV, GaN with a breakdown field strength of 3.3 MV/cm and a band gap energy of 3.4 eV, $Al_xIn_yGa_{1-x-y}N$ with a breakdown field strength of 1.2 to 12 MV/cm and a band gap energy of 0.6 to 6.2 eV, or diamond with a breakdown field strength of about 8.0 MV/cm and a band gap energy of 5.5 eV can be used as the material of the n-type semiconductor layer 11.

The n-type semiconductor substrate 10 may also be formed of a material other than the gallium oxide-based semiconductor. The same material as the n-type semiconductor layer 11 can be used as the material of the n-type semiconductor substrate 10.

In addition, the invention according to claims is not to be limited to the embodiment described above. Further, it should be noted that not all combinations of the features described in the embodiment are necessary to solve the problem of the invention.

Industrial Applicability

Provided are a junction barrier Schottky diode in which variation in the shape of p-type semiconductor portions formed in trenches of an n-type semiconductor layer is suppressed, and a method for producing the same.

Reference Signs List

1 JUNCTION BARRIER SCHOTTKY DIODE
10 N-TYPE SEMICONDUCTOR SUBSTRATE
11 N-TYPE SEMICONDUCTOR LAYER
111 TRENCH
112 MESA-SHAPED PORTION
113 FIRST SURFACE
114 SECOND SURFACE
12, 20 P-TYPE SEMICONDUCTOR PORTION

121, 201 FIRST PORTION
122, 202 SECOND PORTION
13 ANODE ELECTRODE
14 CATHODE ELECTRODE
120 P-TYPE SEMICONDUCTOR
15 PHOTORESIST
16 PHOTORESIST

**Claims**

1. A junction barrier Schottky diode, comprising:

   an n-type semiconductor layer comprising an n-type semiconductor and having a plurality of trenches that open on a first surface;
   a plurality of p-type semiconductor portions that comprise a p-type semiconductor and are provided in contact, respectively, with inner surfaces of the plurality of trenches;
   an anode electrode that is provided on the first surface of the n-type semiconductor layer and on the plurality of p-type semiconductor portions so as to be in contact with a mesa-shaped portion between the plurality of trenches of the n-type semiconductor layer; and
   a cathode electrode provided, directly or through another layer, on a second surface of the n-type semiconductor layer opposite to the first surface,
   wherein electron affinity $\chi_p$ and work function $\varphi_p$ of the p-type semiconductor and electron affinity $\chi_n$ and work function $\varphi_n$ of the n-type semiconductor satisfy a condition represented by an expression: $\chi_n - \chi_p > \varphi_p - \varphi_n$, and
   wherein each of the plurality of p-type semiconductor portions comprises a first portion covering the inner surface of the trench and a second portion covering an edge of an opening of the trench on the first surface of the n-type semiconductor layer.

2. The junction barrier Schottky diode according to claim 1, wherein the trenches are filled respectively with the first portions of the plurality of p-type semiconductor portions.

3. The junction barrier Schottky diode according to claim 1, wherein gaps above the p-type semiconductor portions in the plurality of trenches are filled with a portion of the anode electrode.

4. The junction barrier Schottky diode according to claim 1, wherein the n-type semiconductor layer and the p-type semiconductor portions comprise different semiconductors.

5. The junction barrier Schottky diode according to claim 4, wherein the n-type semiconductor layer comprises a gallium oxide-based semiconductor.

6. The junction barrier Schottky diode according to claim 5, wherein the p-type semiconductor includes $Cu_2O$, NiO, $Ag_2O$, polycrystalline Si, single crystal Si, amorphous Si, SnO, $Rh_2O_3$, $Ir_2O_3$, or CuO.

7. A method for producing a junction barrier Schottky diode, comprising:

   forming a plurality of trenches on a first surface of an n-type semiconductor layer that comprises an n-type semiconductor;
   forming a plurality of p-type semiconductor portions in contact, respectively, with inner surfaces of the plurality of trenches by depositing a p-type semiconductor on the entire surface of the n-type semiconductor layer on the first surface side and patterning the p-type semiconductor;
   forming an anode electrode on the first surface of the n-type semiconductor layer and on the plurality of p-type semiconductor portions so as to be in contact with a mesa-shaped portion between the plurality of trenches of the n-type semiconductor layer; and
   forming a cathode electrode, directly or through another layer, on a second surface of the n-type semiconductor layer opposite to the first surface,
   wherein electron affinity $\chi_p$ and work function $\varphi_p$ of the p-type semiconductor and electron affinity $\chi_n$ and work function $\varphi_n$ of the n-type semiconductor satisfy a condition represented by an expression: $\chi_n - \chi_p > \varphi_p - \varphi_n$, and
   wherein each of the plurality of p-type semiconductor portions comprises a first portion covering the inner surface of the trench and a second portion covering an edge of an opening of the trench on the first surface of the n-type semiconductor layer.

8. The method for producing a junction barrier Schottky diode according to claim 7, wherein in the forming the plurality of p-type semiconductor portions, the plurality of p-type semiconductor portions are formed by patterning a single p-type semiconductor film using lithography.

9. The method for producing a junction barrier Schottky diode according to claim 7, wherein in the forming the plurality of p-type semiconductor portions, the plurality of p-type semiconductor portions are formed by patterning using lift-off.

## FIG. 1

## FIG. 2A

## FIG. 2B

## FIG. 2C

## FIG. 3A

## FIG. 3B

## FIG. 3C

113  111      111      111

*FIG. 4A*

11

10

113      16      16      16      16

111

*FIG. 4B*

11

10

120

113

16

111

*FIG. 4C*

11

10

## FIG. 5

## FIG. 6A

120
111
11
10

## FIG. 6B

50     50     50
111    111    111
11
10

## FIG. 6C

13
50    50    50
11
10
14

## FIG. 7A

## FIG. 7B

## FIG. 7C

## FIG. 8A

## FIG. 8B

## FIG. 8C

## INTERNATIONAL SEARCH REPORT

| International application No. |
|---|
| **PCT/JP2023/043807** |

**A. CLASSIFICATION OF SUBJECT MATTER**

*H01L 29/872*(2006.01)i; *H01L 21/329*(2006.01)i; *H01L 29/47*(2006.01)i; *H01L 29/861*(2006.01)i; *H01L 29/868*(2006.01)i
FI: H01L29/86 301F; H01L29/91 K; H01L29/86 301P; H01L29/86 301D; H01L29/48 F; H01L29/48 P; H01L29/48 D; H01L29/91 F; H01L29/91 A

According to International Patent Classification (IPC) or to both national classification and IPC

**B. FIELDS SEARCHED**

Minimum documentation searched (classification system followed by classification symbols)

H01L29/872; H01L21/329; H01L29/47; H01L29/861; H01L29/868

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2022-154364 A (TOYOTA JIDOSHA KABUSHIKI KAISHA) 13 October 2022 (2022-10-13) paragraphs [0010]-[0082], fig. 1-6 | 1-9 |
| Y | JP 2021-103747 A (NOVEL CRYSTAL TECH INC) 15 July 2021 (2021-07-15) paragraphs [0048], [0057], [0060], fig. 4, 5 | 1-9 |
| Y | JP 2009-130013 A (NIPPON LIGHT METAL CO LTD., KYOTO UNIV) 11 June 2009 (2009-06-11) paragraphs [0010], [0029], fig. 4 | 1-9 |
| Y | JP 2013-222858 A (UNIV OF ELECTRO-COMMUNICATIONS, NIPPON DENGYO KOSAKU CO., LTD.) 28 October 2013 (2013-10-28) paragraphs [0023]-[0049], fig. 1-3 | 1-9 |
| Y | JP 2013-522876 A (CREE INC.) 13 June 2013 (2013-06-13) paragraphs [0044]-[0059], [0077]-[0087], fig. 2, 3, 10, 12 | 1-9 |

✓ Further documents are listed in the continuation of Box C.　　✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **01 February 2024** | **13 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| --- |
| **PCT/JP2023/043807** |

### C. DOCUMENTS CONSIDERED TO BE RELEVANT

| Category* | Citation of document, with indication, where appropriate, of the relevant passages | Relevant to claim No. |
| --- | --- | --- |
| Y | JP 2019-102552 A (FUJI ELECTRIC CO., LTD.) 24 June 2019 (2019-06-24)<br>     paragraphs [0017]-[0055], fig. 1-8 | 3 |
| A | | 1, 2, 4-9 |
| Y | WO 2019/155768 A1 (MITSUBISHI ELECTRIC CORPORATION) 15 August 2019 (2019-08-15)<br>     paragraphs [0016]-[0116], fig. 1-5 | 9 |
| A | | 1-8 |

Form PCT/ISA/210 (second sheet) (July 2022)

## INTERNATIONAL SEARCH REPORT
### Information on patent family members

International application No.

**PCT/JP2023/043807**

| Patent document cited in search report | | | Publication date (day/month/year) | Patent family member(s) | | | Publication date (day/month/year) |
|---|---|---|---|---|---|---|---|
| JP | 2022-154364 | A | 13 October 2022 | US | 2022/0320270 | A1 | |
| | | | | paragraphs [0059]-[0137], fig. 1-6 | | | |
| | | | | CN | 115148784 | A | |
| JP | 2021-103747 | A | 15 July 2021 | US | 2023/0043402 | A1 | |
| | | | | paragraphs [0067], [0076], [0079], fig. 4, 5 | | | |
| | | | | WO | 2021/131893 | A1 | |
| | | | | CN | 114846590 | A | |
| JP | 2009-130013 | A | 11 June 2009 | CN | 101868862 | A | |
| | | | | paragraphs [0045], [0072], fig. 4 | | | |
| | | | | KR | 10-2010-0087017 | A | |
| JP | 2013-222858 | A | 28 October 2013 | (Family: none) | | | |
| JP | 2013-522876 | A | 13 June 2013 | US | 2011/0215338 | A1 | |
| | | | | paragraphs [0050]-[0065], [0083]-[0093], fig. 2, 3, 10, 12 | | | |
| | | | | EP | 2545587 | A1 | |
| | | | | TW | 201320354 | A | |
| JP | 2019-102552 | A | 24 June 2019 | US | 2019/0165187 | A1 | |
| | | | | paragraphs [0020]-[0057], fig. 1-8 | | | |
| WO | 2019/155768 | A1 | 15 August 2019 | US | 2021/0074826 | A1 | |
| | | | | paragraphs [0028]-[0128], fig. 1-5 | | | |
| | | | | CN | 111656532 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019036593 A

**Non-patent literature cited in the description**

- *Appl. Phys. Lett.*, 2017, vol. 111, 093501
- *Appl. Phys. Lett.*, 2020, vol. 117, 022104